# EUROPEAN PATENT APPLICATION

(11) **EP 2 447 887 A2**
(43) Date of publication of application: **02.05.2012**
(21) Application number: 11186245.4
(22) Date of filing: 21.10.2011
(51) Int. Cl.: G06K 19/077, H01Q 1/00, H01Q 1/38, H01Q 7/00, H01B 3/00, H05K 1/16

(54) **Integrated PCB UHF RFID matching network/antenna**

(30) Priority: 29.10.2010 US 916268
(71) Applicant: NXP B.V., 5656 AG Eindhoven (NL)
(72) Inventor: Manzi, Giuliano, 5656 AG Eindhoven (NL)
(74) Representative: Krott, Michel

(57) **Abstract**

A matching network (205) is integrated into a multilayer printed circuit board (110) containing an RFID integrated circuit (120) to provide both an antenna (150,155,210) and a matching network for the RFID integrated circuit in the ultra high frequency regime.

## Description

### BACKGROUND OF THE INVENTION

In the electronics industry it is typically desirable to be able to accurately track products in the production process. Additionally, it is typically desirable to manage product lifecycles efficiently and precisely.

To accurately track a product through its lifecycle typically requires a solution that can easily record and provide information such as the production process history. This may be accomplished by attaching individual identifiers on the products. Currently barcodes are the electronics industry standard for individually identifying products but these lack the ability to record additional information. A solution that allows the storing of information related to the product's lifecycle is a radio frequency identification (RFID) solution.

Typical RFID solutions based on tags cannot generally be used for electronics products such as printed circuit boards because the processes used in the manufacturing such as reflow processes, heat processes and chemical processes are not compatible with the use of RFID tags. Using the RFID solution with PCB products can be accomplished by having a dedicated solution that integrates RFID directly into the PCB manufacturing design and using dedicated integrated circuit (IC) packaging.

### BRIEF DESCRIPTION OF THE EMBODIMENTS

Fig. 1a shows an embodiment in accordance with the invention.
Fig. 1b shows an embodiment in accordance with the invention.
Fig. 1c shows an embodiment in accordance with the invention.
Fig. 1d shows an embodiment in accordance with the invention.
Fig. 1e shows an embodiment in accordance with the invention.
Fig. 2 shows an embodiment in accordance with the invention.
Fig. 3 shows a multilayer inductive coil for an embodiment in accordance with the invention.
Fig. 4 shows fully a integrated UHF RFID IC with a multilayer inductive coil and UHF RFID IC in accordance with an embodiment of the invention.
Figs. 5a-5e show steps for making an embodiment in accordance with the invention.

### DETAILED DESCRIPTION OF THE INVENTION

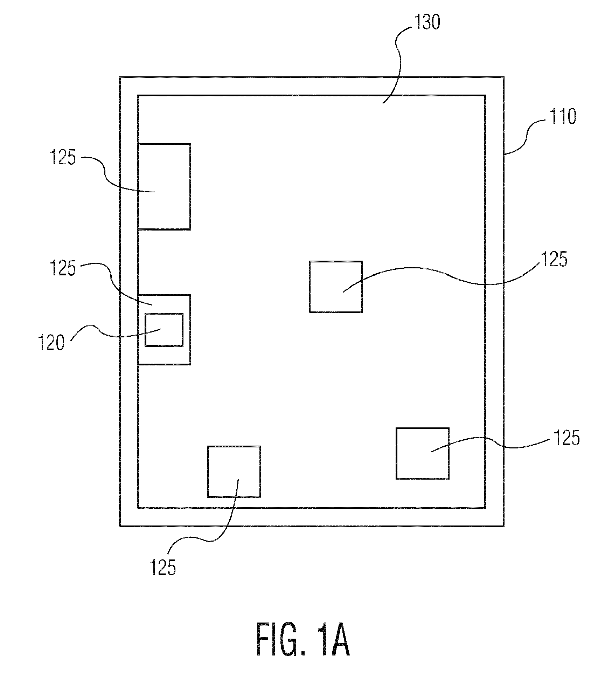

In accordance with the invention, printed circuit board tracking and identification are enabled along with electronic equipment tracking and identification. Distribution history and electronic equipment lifecycle and process history may be tracked using fully integrated ultra-high frequency (UHF) RFID IC (including a matching network) 120 (see Fig. 1a).

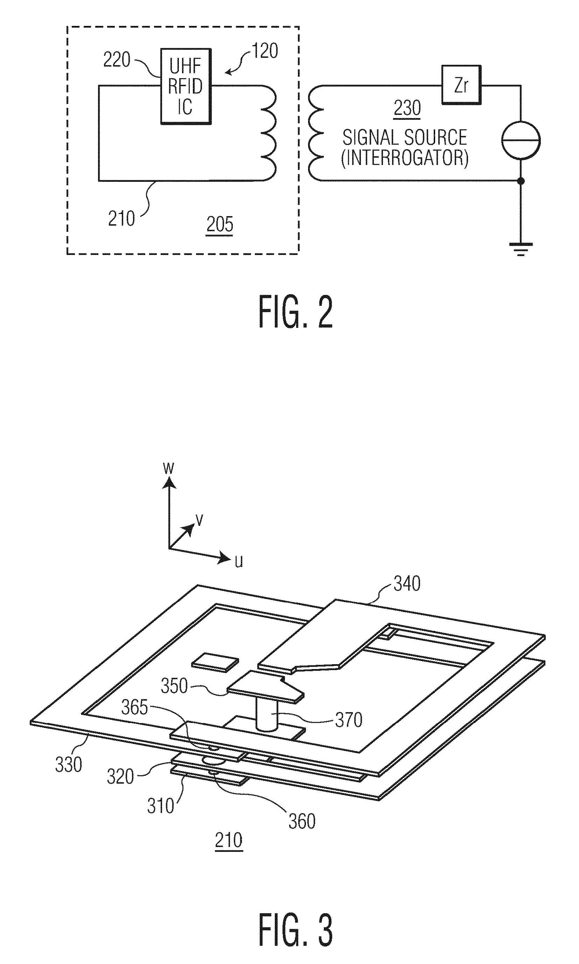

In an embodiment in accordance with the invention, fully integrated UHF RFID IC (including a matching network) 120 is incorporated into multilayered printed circuit board (PCB) 110. Fully integrated UHF RFID IC 120 typically uses only a small area of multilayered PCB 110, for example, a 5 mm by 5 mm space results in a 25 mm² footprint that may be further reduced to 10 mm². The dimension of the required footprint is a function of the number of layers and of the relative dielectric constant of PCB 110. More layers and/or a higher relative dielectric constant for PCB 110 allow for a smaller footprint for fully integrated UHF RFID IC 120. Fully integrated UHF RFID IC 120 can be located in any suitable area 125 available on PCB 110 as shown in Fig. 1a. Area 130 is space that is already occupied on PCB 110 and is not available for locating fully integrated UHF RFID IC 120. Fully integrated UHF RFID IC 120 has an antenna function and this allows power to be received from interrogator 230 (see Fig. 2) for activation and establishment of communications for the identification process. Fully integrated UHF RFID IC 120 provides both impedance matching and a short range antenna to accommodate worldwide UHF bands (typically from about 860 Mhz to about 965 Mhz ) while complying with the EPC Global C 1 G2 standard using a single RFID tag. No electrical connections are typically required to additional antennas and PCB traces. For short range identification on the order of 10 cm or less no electrical connection or coupling to an additional antenna on PCB 110 is required to enable communication between the interrogator 230 (See Fig. 2) and PCB 110.

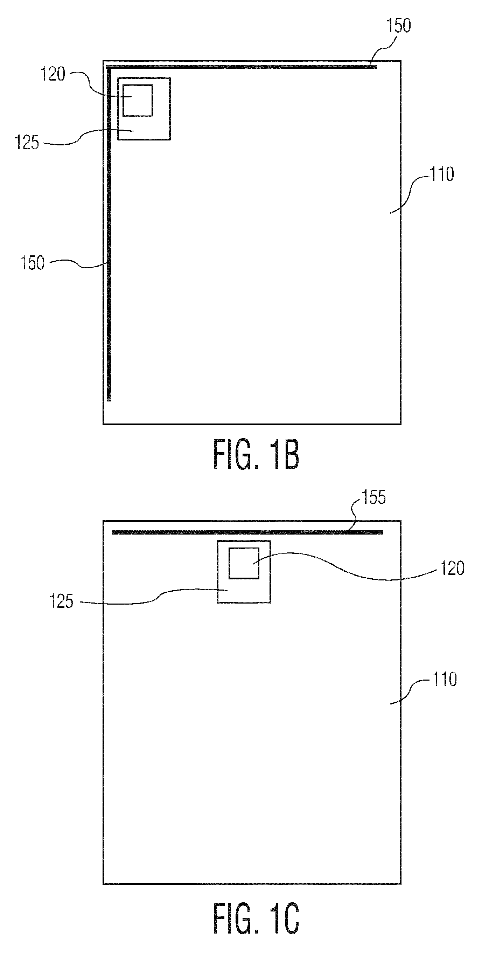

For extended range identification greater than about 10cm to about 2m, embodiments in accordance with the invention use a special geometrical configuration that adapts the traces located on top of PCB 110 or in any of the layers of PCB 110 to function as resonating antennas at the UHF RFID frequency. Resonating antennas 150 and 155 are magnetically or electrically coupled to the fully integrated UHF RFID IC 120 as shown in Figs. 1b and 1c, respectively. In Fig. 1b, fully integrated UHF RFID IC 120 is located at a corner of PCB 110 and magnetically coupled or electrically coupled to resonating dipole 150 which occupies space on two sides of PCB 110 as shown in Fig. 1b. Fig. 1c shows another embodiment in accordance with the invention where resonating dipole 155 is on one side of PCB 110 and is magnetically or electrically coupled to fully integrated UHF RFID IC 120. In the event of electrical coupling, the midpoint of resonating dipole 150 or 155 is connected at its midpoint to the midpoint of multilayer inductive coil 210 (see Fig. 2).

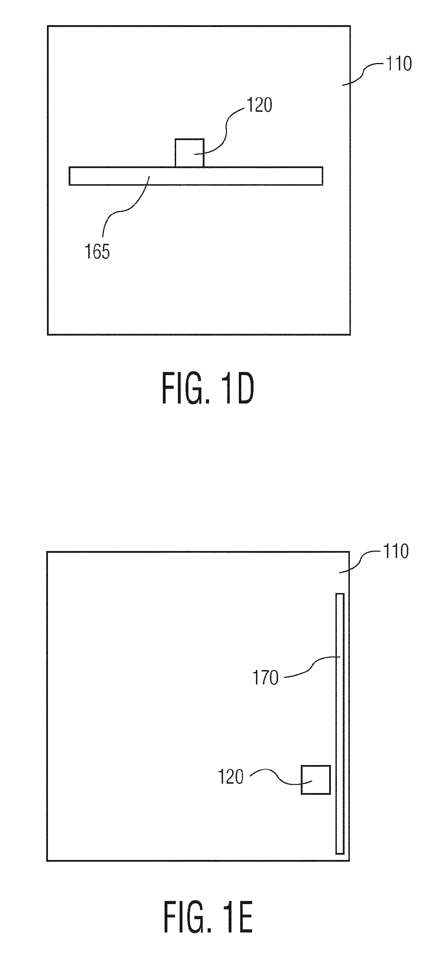

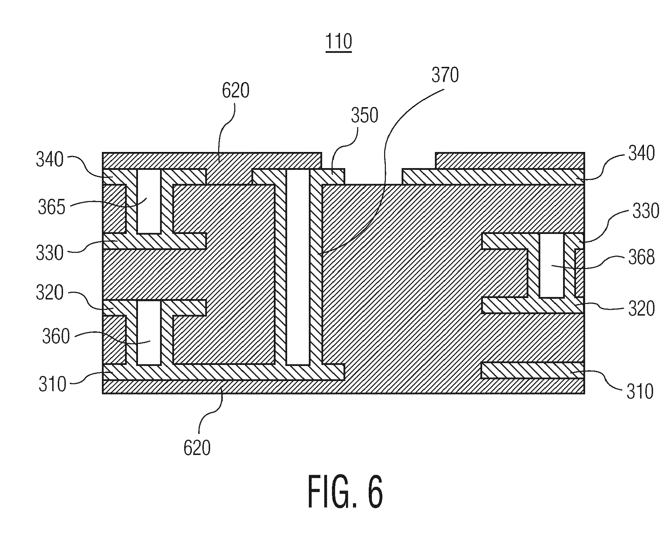

Another embodiment in accordance with the invention is shown in Figs. 1d and 1e in top view. Fully integrated UHF RFID IC 120 is electrically coupled to the ground plane of PCB 110 using resonating slots 165 and 170 shown in Figs. 1d and 1e, respectively, that are located in the ground plane of PCB 110. With reference to Fig. 6, when only two layers are present or the electronic components and signal traces reside only on the top layer of PCB 110, the ground plane is located in the layer occupied by trace 310. In the case of more than two layers, with electronic components and signal traces on both the top and bottom layers of PCB 110, the ground plane is typically located in one of the middle layers such as the layer occupied by trace 320 or trace 330 in Fig. 6. The ground plane functions as an RF (radio frequency) reflector that receives power from the electromagnetic wave radiated by the reader to fully integrated UHF RFID IC 120.

Fig. 2 shows matching circuit 205 with fully integrated UHF RFID IC 120 and interrogator 230 in an embodiment in accordance with the invention. Multilayer inductive coil 210 acts as an antenna and also provides an impedance match to the impedance of UHF RFID IC 220 to allow the maximum power to be transferred between multilayered inductive coil 210 and UHF RFID IC 220. Typically, the imaginary part of the impedance of UHF RFID IC 120 can be fully matched but the full matching of the real part of the impedance of UHF RFID IC 120 is more difficult due to the low impedance of multilayered inductive coil 210. A typical matching of -2 dB for the real part of the impedance is obtained using only the multilayered inductive coil 210. Adding passive resistance or capacitance matching can provide improved impedance matching to UHF RFID IC 120 and provides an improved Q. Multilayer inductive coil 210 can typically be incorporated into the multilayer PCB production processes used to make PCB 110. Multilayer inductive coil 210 receives the magnetic field of the propagating electromagnetic waves sent from signal source/interrogator 230 having equivalent input impedance, Zr. The magnetic field from interrogator 230 induces a current flow in multilayer inductive coil 210. This current flow is used to power UHF RFID IC 220 and establish communication with interrogator 230. As shown in Fig. 2, the matching network comprises multilayer inductive coil 210 in parallel with UHF RFID IC 220. Because multilayer inductive coil 210 is implemented as a multilayer coil (see Fig. 3), multilayer inductive coil 210 also functions as an impedance transformer for the electromagnetic wave received from signal source/interrogator 230.

Fig. 3 shows multilayer inductive coil 210 in a perspective view, showing multiple coil layers (typically the traces in different layers of PCB 110 comprise the layers of multilayer inductive coil 210) or traces 310, 320, 330 and 340 of multilayer inductive coil 210 which act as multiple coil windings to provide impedance matching and the integrated antenna structure for UHF RFID IC 220. Traces 310, 320, 330 and 340 may be made from copper, aluminum or other suitable materials. Traces 310 and 320 are electrically coupled together using metallized via 360, traces 330 and 340 are electrically coupled together using metallized via 365, traces 320 and 330 are electrically coupled together using metallized via 368 (not shown in Fig. 3-see Fig. 6) and trace 350 is electrically coupled to trace 310 using metallized via 370. Typical dimensions for traces 310, 320, 330, 340 and 350 are widths typically in the range from about 0.1 mm to about 0.5 mm with a thickness typically in the range from about 10 µm to about 20 µm.

The total length of multilayer inductive coil 210 depends on the input impedance of UHF RFID IC 220 that needs to be impedance matched. The total number of layers needed to construct multilayer inductive coil 210 typically depends on the total coil length needed and the amount of area that is available on PCB 110 for UHF RFID IC 220. For example, assuming multilayer coil 210 needs to be 40 mm in length to match the impedance of UHF RFID IC 220 and the available area on PCB 110 is limited to 5 mm by 5 mm, at least two layers are required. Then, consideration of the applicable mechanical and electromagnetic constraints, such as the maximum distance between traces in different layers and the electromagnetic properties of the materials used (e.g. relative dielectric constant, dielectric losses) in the construction of multilayer coil 210 may result in the need for constructing multilayer coil 210 out of three or more layers. Typical input impedances for UHF RFID IC 220 are typically in the range from about 10-140iΩ to about 25-240iΩ which translates to a length for multilayer inductive coil 210 from about 35 mm to about 50 mm when using PCB material having a relative dielectric constant of εᵣ ~ 4.2 which is a typical value for FR-4 type material (a worldwide standard PCB dielectric material). Note that the length of multilayer inductive coil 210 depends on the specific electromagnetic properties of the PCB material. For example, using a PCB material having a relatively high dielectric constant (PTFE laminated PCB material allows an εᵣ ~ 10) or a ferromagnetic PCB material (typically produced by having ferroelectric layers introduced between different PCB layers or on top of a PCB layer) allows a reduction in the length of the trace needed to obtain a specific inductance value for multilayer coil 210.

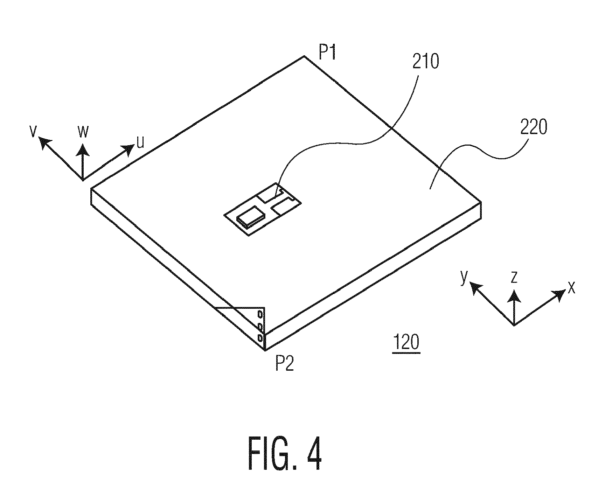

Fig. 4 shows fully integrated UHF RFID IC 120 with multilayer inductive coil 210 and UHF RFID IC 220. In an embodiment in accordance with the invention, UHF RFID IC 220 is mounted on PCB 110 typically using a reflow solder process and centered on multilayer inductive coil 210 as shown in Fig. 4.

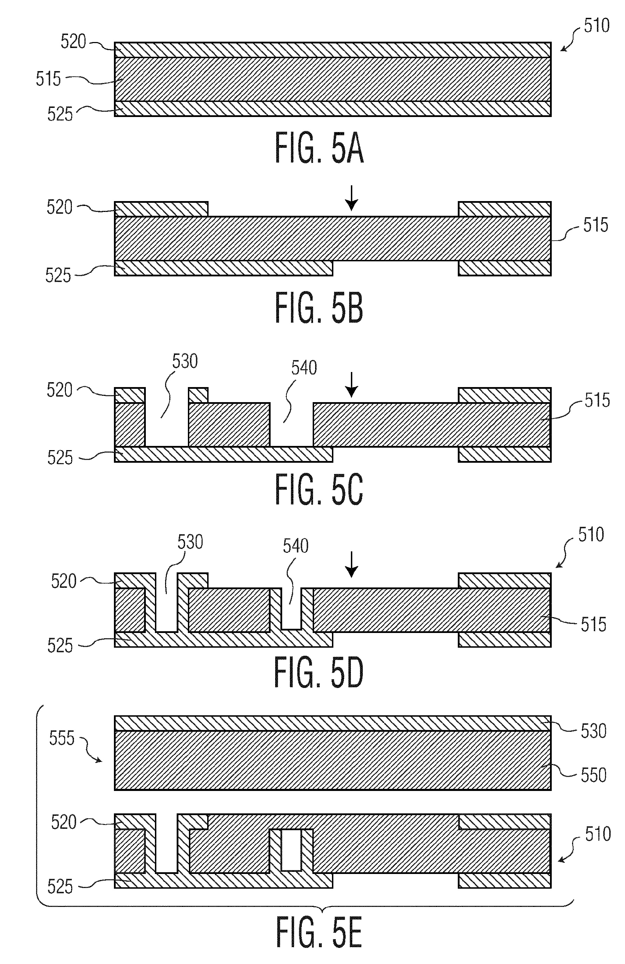

PCB 110 in Fig. 1 is a multilayer PCB having internal trace layers in accordance with the invention and is typically formed by bonding together separately etched or laser cut thin boards. Figs. 5a-d show the steps for making layer 510 of multilayer PCB 110 in an embodiment in accordance with the invention. In Fig. 5a, non-conductive substrate 515 typically has metal sheets 520 and 525, typically copper, laminated to both sides of substrate 515 and is a two sided, blank, printed circuit board. In Fig. 5b, metal sheets 520 and 525, typically copper, are etched or laser cut to produce the trace that makes up a layer of multilayer inductive coil 210. In Fig.. 5c, laser drilling is typically used to make vias 530 and 540 in substrate 515 and metal layer 520. Fig. 5d shows the metallization of vias 530 and 540 with metal, typically copper. Finally, Fig. 5e shows the lamination of layer 510 to blank PCB 555 to become part of PCB 110. Blank PCB 555 comprises an insulating substrate 550 with metal sheet 530 laminated to one side. The process described in steps 5a-e is then repeated as needed to make multilayer PCB 110 (see Fig. 6). Note that depending on the design requirements for multilayer coil 210, embodiments in accordance with the invention may have more or less layers than are shown in Fig. 6.

A cross-sectional view of multilayer PCB 110 in accordance with the invention is shown in Fig. 6. Solder masks 620 are applied to both the top and bottom of multilayer PCB 110 to prevent solder from bridging between conductors and creating a short circuit. Fig. 6 shows traces 310, 320, 330, 340 and 350 in cross-section. Traces 310, 320, 330, 340 and 350 together comprise multilayer inductive coil 210 which is shown in Fig. 3 along with metallized vias 360, 365, 368 and 370 that function to electrically couple traces 310, 320, 330, 340 and 350 as shown in Fig. 6.

While the invention has been described in conjunction with specific embodiments, it is evident to those skilled in the art that many alternatives, modifications, and variations will be apparent in light of the foregoing description. Accordingly, the invention is intended to embrace all other such alternatives, modifications, and variations that fall within the spirit and scope of the appended claims.

## Claims

1. An integrated PCB RFID integrated circuit comprising:
- an RFID integrated circuit electrically coupled to a multilayered printed
- circuit board having a first plurality of traces that are distributed over the
- multilayered printed circuit board to form a multilayer inductive coil for
- the RFID integrated circuit.

2. The integrated PCB RFID integrated circuit of Claim 1 wherein the multilayer inductive coil is adapted for UHF frequencies.

3. The integrated PCB RFID integrated circuit of Claim 1 wherein the plurality of traces comprise aluminum.

4. The integrated PCB RFID integrated circuit of Claim 1 wherein the multilayer inductive coil is electrically coupled to the midpoint of a trace forming a dipole antenna that is attached onto the multilayered printed circuit.

5. The integrated PCB RFID integrated circuit of Claim 1 wherein the multilayer inductive coil is magnetically coupled to a trace forming a dipole antenna that is attached onto the multilayered printed circuit board.

6. The integrated PCB RFID integrated circuit of Claim 1 wherein the RFID integrated circuit is electrically coupled to a ground plane of the multilayered printed circuit board using resonating slots.

7. The integrated PCB RFID integrated circuit of Claim 1 wherein the multilayered printed circuit board has two layers.

8. The integrated PCB RFID integrated circuit of Claim 1 wherein the multilayer inductive coil is adapted to provide impedance matching for the RFID integrated circuit.

9. The integrated PCB RFID integrated circuit of Claim 1 adapted to receive power from an interrogator.

10. The integrated PCB RFID integrated circuit of Claim 1 wherein the plurality of traces are electrically coupled together using metallized vias.

11. A method for making an PCB RFID integrated circuit comprising:
- providing an RFID integrated circuit;
- electrically coupling the RFID circuit to a multilayered printed circuit board;
- forming a plurality of traces that are distributed over the multilayered printed circuit board; and
- forming a multilayer inductive coil for the RFID integrated circuit from the plurality of traces.

12. The method of Claim 11 wherein the multilayer inductive coil is magnetically coupled to a trace forming a dipole antenna that is attached onto the multilayered printed circuit board.

13. The method of Claim 11 wherein the RFID integrated circuit is electrically coupled to a ground plane of the multilayered printed circuit board using resonating slots.

14. The method of Claim 11 wherein the multilayer inductive coil is adapted for UHF frequencies.

15. The method of Claim 11 wherein the multilayer inductive coil is adapted to provide impedance matching for the RFID integrated circuit.
